# EUROPEAN PATENT APPLICATION

(11) **EP 2 395 366 A1**
(43) Date of publication of application: **14.12.2011**
(21) Application number: 10738413.3
(22) Date of filing: 21.01.2010
(51) Int. Cl.: G01R 33/02, G01R 33/07, G01R 33/09, H01L 43/02, H01L 43/04, H01L 43/08

(54) **MAGNETIC DETECTOR**

(30) Priority: 05.02.2009 JP 2009024487
(71) Applicant: Alps Electric Co., Ltd., Tokyo 145-8501 (JP)
(72) Inventor: ANDO, Hideto, Tokyo 145-8501 (JP); SATO, Atsushi, Tokyo 145-8501 (JP); SASAKI, Shinichi, Tokyo 145-8501 (JP); KITASHIMA, Takumi, Tokyo 145-8501 (JP); NOGUCHI, Takafumi, Tokyo 145-8501 (JP)
(74) Representative: Klunker . Schmitt-Nilson . Hirsch
(86) International application number: PCT/JP2010/050678
(87) International publication number: WO 2010/090075

(57) **Abstract**

[Object] In particular, an object is to provide a magnetic detection device that is capable of reducing, compared with the related art, the effect of magnetism from the Ni plating layer on the magnetic sensor with a configuration in which the magnetic sensor is stacked on the electrode patterns in plan view.

[Solution] A magnetic sensor 21 is mounted on a ground electrode pattern 12, which is formed on a substrate 11, on an insulating film 20. The insulating film 20 is formed with a size that spreads out around the magnetic sensor 21. The ground electrode pattern 12 is provided with an exposed part 12c, where a Au plating layer 23 is formed on the electrode pattern surface on a Ni plating layer 22 and not covered with the insulating layer 20. Then, the magnetic sensor 21 is connected by wire bonding to the exposed part 12c at a distance from the magnetic sensor 21 through the insulating film 20.

## Description

### Technical Field

The present invention relates to a magnetic detection device in which a magnetic sensor and an electrode pattern are connected by wire bonding, a connecting surface layer being formed on the pattern surface on a Ni plating layer.

### Background Art

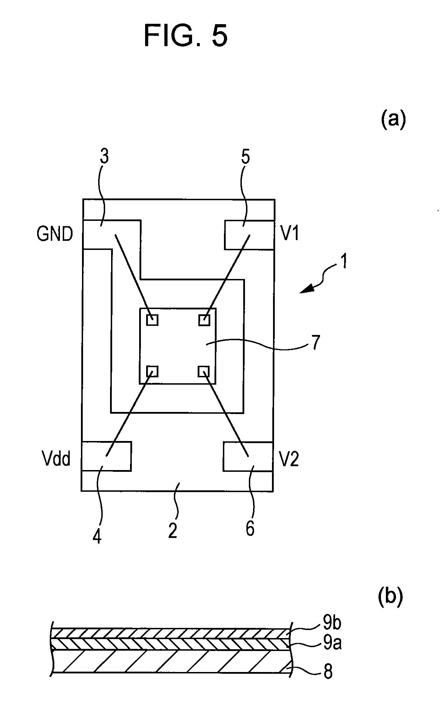

Fig. 5(a) is a plan view of a magnetic detection device having a known structure. In the magnetic detection device 1 illustrated in Fig. 5(a), a ground electrode pattern 3, an input electrode pattern 4, and output electrode patterns 5 and 6 are formed on a substrate 2, and a magnetic sensor 7 is mounted on the ground electrode pattern 3. The magnetic sensor 7 and the electrode patterns 3 to 6 are connected by wire bonding.

For example, a magnet, which is not shown, opposes the magnetic sensor in the height direction. Then, a change in the magnetic field due to movement of the magnet is detected by the magnetic sensor, and, in this way, the movement of the magnet can be detected.

For example, the electrode patterns 3 to 6 are patterned with copper foil 8, as illustrated in Fig. 5(b), and on the entire surface of the copper foil 8, a Au plating layer 9b is formed on a Ni plating layer 9a. In this way, by disposing the Ni plating layer 9a as a base of the Au plating layer 9b, the adhesiveness of the copper foil 8 and the Au plating layer 9b can be improved. The Ni plating layer 9a and the Au plating layer 9b are formed by an electroplating method.

Thus, with the known structure illustrated in Fig. 5(a), the Ni plating layer 9a exists directly below the magnetic sensor 7.

### Citation List

### Patent Literature

PTL 1: Japanese Unexamined Patent Application Publication No. 6-300869
PTL 2: Japanese Unexamined Patent Application Publication No. 2006-276983

### Summary of Invention

### Technical Problem

With the known structure, however, there is a problem in that highly precise magnetic detection cannot be performed because the Ni plating layer 9a is magnetized by a magnetic field of the magnet or a disturbance magnetic field, affecting the magnetic sensor 7 with the magnetism from the magnetized Ni plating layer 9a.

For example, PTL 1 describes that Ni plating applied as a base of Au plating disposed on electrodes is easily magnetized, and thus, a magnetic sensor is to be disposed at a position 14 mm or more away from the electrodes (paragraph

### [0013] in PTL 1).

However, PTL 1 does not provide a solution for preventing the effect of magnetism from the magnetized Ni plating layer 9a in a configuration in which the magnetic sensor 7 is stacked on the ground electrode pattern 3 in plan view as illustrated in Fig. 5(a). For example, when all electrode patterns 3 to 6 are disposed far a distance from the mounting position of the magnetic sensor 7 in accordance with PTL 1, the effect of the magnetism from the Ni plating layer 9a can be reduced, but it is clear that size reduction of the magnetic detection device cannot be promoted, and thus, PTL 1 cannot be accepted.

Accordingly, the present invention solves the above-described problem and, in particular, compared with the related art, is capable of reducing the effect of magnetism from the Ni plating layer on the magnetic sensor with a configuration in which the magnetic sensor is stacked on the electrode patterns in plan view. An object is to provide a magnetic detection device.

### Solution to Problem

The present invention includes a magnetic sensor, wherein the magnetic sensor is mounted on an electrode pattern formed on a substrate on an insulating film, and the insulating film is formed with a size spreading out around the magnetic sensor, wherein the electrode pattern is provided with an exposed part where a connecting surface layer is formed on the electrode pattern surface on a Ni plating layer and not covered with the insulating layer, and the magnetic sensor is connected by wire bonding to the exposed part at a distance from the magnetic sensor through the insulating film.

According to the present invention, the insulating film is interposed between the magnetic sensor and the electrode pattern, and the connecting surface layer is formed only on the exposed part of the electrode pattern, which is not covered with the insulating film, on the Ni plating layer. Then, the magnetic sensor is connected by wire bonding to the exposed part at a distance from the magnetic sensor through the insulating film.

Thus, unlike in the related art, according to the present invention, a Ni plating layer is not provided below the magnetic sensor, and the Ni plating layer is disposed at a position a distance from the magnetic sensor (position of the exposed part). Therefore, in also the configuration in which the magnetic sensor is stacked on the ground electrode pattern in plan view, the effect of magnetism from the Ni plating layer on the magnetic sensor can be prevented, and size reduction, as well as highly precise magnetic detection, is possible.

According to the present invention it is preferable that an opening reaching the electrode pattern be formed in the insulating film at a position a distance from the magnetic sensor, and the magnetic sensor be connected by wire bonding to the exposed part formed in the opening.

In this way, most of the electrode pattern, excluding the opening, can be covered with the insulating film, and the area where the Ni plating layer 22 is formed can be sufficiently small. Furthermore, the formation position of the opening can be freely set and wire bonding can be appropriately and stably performed by taking into consideration the wire bonding position of other electrode patterns disposed at a position a distance from the magnetic sensor.

In the present invention, it is preferable that the magnetic sensor be mounted on a ground electrode pattern on the insulating film, an input electrode pattern and an output electrode pattern be disposed at positions a distance from the insulating film, a connecting surface layer e formed on the pattern surfaces of the input electrode pattern and the output electrode pattern on a Ni plating layer, and the magnetic sensor be connected by wire bonding to each of the exposed part of the ground electrode pattern, the input electrode pattern, and the output electrode pattern.

Electric field noise can be efficiently prevented by the shielding effect of the ground electrode pattern. Furthermore, in the present invention, it is preferable that the ground electrode pattern include a narrow part and a wide part, and the magnetic sensor be mounted within the wide part in plan view. In this way, the above-mentioned shielding effect can be improved, as well as reducing the resistance of the ground electrode pattern itself, so as to even more effectively reduce noise.

Furthermore, in the present invention, it is preferable that a plurality of magnetic sensors be mounted on the ground electrode pattern on the insulating film, a shared opening reaching the ground electrode pattern be formed in the insulating film at a position a distance from the magnetic sensors, and the magnetic sensors be connected by wire bonding to the exposed part formed in the shared opening. In the configuration in which a plurality of magnetic sensors is provided, by forming the shared opening in the insulating film, size reduction of the magnetic detection device can be promoted, compared with when openings are provided separately and wire-bonded or when wires are lead out for connection to the position of the ground electrode pattern exposed outside the insulating film.

In particular, in the above, it is preferable that the magnetic sensors surround the shared opening and be connected by wire bonding to the exposed part formed in the shared opening, and wires be lead out from electrode pads of the magnetic sensors to outside the insulating film and connected to the input electrode pattern and the output electrode pattern. In this way, interference between the wires connecting the magnetic sensors and the ground electrode pattern and the wires connecting the magnetic sensor, the input electrode pattern, and the output electrode patterns does not have to be considered, and wire bonding can be performed even more appropriately and stably.

Furthermore, in the present invention, it is preferable that the magnetic sensor and an IC be mounted on the same ground electrode pattern on the insulating film, and the IC, together with the magnetic sensor, be connected by wire bonding to the exposed part of the ground electrode pattern.

Since the magnetic sensor and the IC are mounted on the shared ground electrode pattern, the magnetic sensor and the exposed part of the ground electrode pattern are wire-bonded, and the IC and the exposed part of the ground electrode pattern are wire-bonded, the ground electrode pattern does not have to be lead out separately for the magnetic sensor and the IC. Moreover, in the above-described configuration in which the opening is formed in the insulating film, it is possible to perform wire bonding to the magnetic sensor and the IC in the shared opening. Accordingly, with the present invention, size reduction of the magnetic detection device can be effectively promoted.

### Advantageous Effects of Invention

According to the present invention, a Ni plating layer is not provided below a magnetic sensor, and the Ni plating layer is disposed at a position a distance from the magnetic sensor (position of an exposed part). Thus, in also the configuration in which the magnetic sensor is stacked on the ground electrode pattern in plan view, the effect of magnetism from the Ni plating layer on the magnetic sensor can be prevented, and size reduction, as well as highly precise magnetic detection, is possible.

### Brief Description of Drawings

[Fig. 1] Fig. 1 is a schematic view of a magnetic detection device according to a first embodiment; Fig. 1(a) is a plan view of the magnetic detection device; Fig. 1(b) is a partially enlarged sectional view of an exposed part of an electrode pattern; and Fig. 1(c) is a sectional view taken along line A-A in the thickness direction of the magnetic detection device in Fig. 1(a).
[Fig. 2] Fig. 2 is a plan view of a magnetic detection device according to a second embodiment.
[Fig. 3] Fig. 3 is a plan view of a magnetic detection device according to a third embodiment.
[Fig. 4] Fig. 4 is a plan view of a magnetic detection device according to a fourth embodiment.
[Fig. 5] Fig. 5(a) is a plan view of a known magnetic detection device; and Fig. 5(b) is a partially enlarged sectional view of an electrode pattern.

### Description of Embodiments

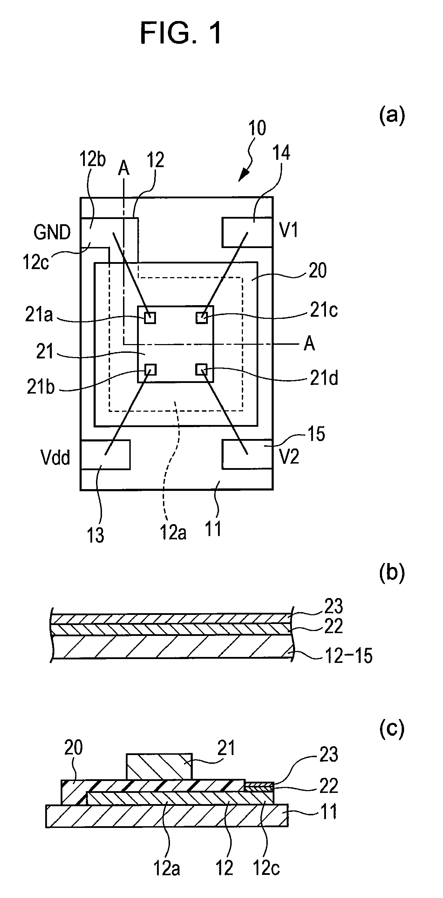

Fig. 1 is a schematic view of a magnetic detection device according to a first embodiment; Fig. 1(a) is a plan view of the magnetic detection device; Fig. 1(b) is a partially enlarged sectional view of an exposed part of an electrode pattern; and Fig. 1(c) is a sectional view taken along line A-A in the thickness direction of the magnetic detection device in Fig. 1(a).

The magnetic detection device 10, which is illustrated in Fig. 1, includes a substrate 11, a ground electrode pattern 12, an input electrode pattern 13, and output electrode patterns 14 and 15, which are formed on the substrate surface, as wells as an insulating film 20 and a magnetic sensor 21. The substrate 11 is a glass epoxy substrate, a flexible printed substrate, etc.

As illustrated in Fig. 1(a), the ground electrode pattern 12 is formed with a wide part 12a and a narrow part 12b.

As illustrated in Figs. 1(a) and 1(c), the insulating film 20 is formed on the wide part 12a of the ground electrode pattern 12. The insulating film 20 is, for example, a resist. The insulating film 20 may be formed of an inorganic insulating material but if it is formed of an organic insulating material, the insulating film 20 can be easily formed with a large thickness, and the wide part 12a can be reliably covered with the insulating film 20.

As illustrated in Fig. 1(a), the entire upper surface of the wide part 12a of the ground electrode pattern 12 is covered with the insulating film 20. Then, the magnetic sensor 21 is mounted on the insulating film 20 with an adhesive, etc. With the configuration of Fig. 1(a), the magnetic sensor 21 is positioned at substantially the center of the wide part 12a. As illustrated in Fig. 1(a), the insulating film 20 is formed with a size that spreads out around the magnetic sensor 21.

A magnetic detection element (not shown) is embedded in the magnetic sensor 21. The magnetic detection element is a GMR element, an ARM element, a TMR element, a hole element, etc. Inside the magnetic sensor 21, the magnetic detection element is electrically connected to electrode pads 21a to 21d on the sensor surface.

With the ground electrode pattern 12, the input electrode pattern 13, and the output electrode patterns 14 and 15 formed with, for example, copper foil, a Ni plating layer 22 is formed by an electroplating method on the copper foil surface an exposed copper surface of the ground electrode pattern 12 (the portion of the narrow part 12b in Fig. 1(a)) and the copper foil surfaces of the input electrode pattern 13 and the output electrode patterns 14 and 15 after the surface of the wide part 12a of the ground electrode pattern 12 is covered with the insulating film 20, and furthermore, for example, a Au plating layer (connecting surface layer) 23 is formed by an electroplating method on the surface of the Ni plating layer 22. Thus, the electrode patterns 12 to 15 have a laminated structure as illustrated in Fig. 1(b), except for the wide part 12a covered with the insulating film 20. As the connecting surface layer 23, in addition to Au, AlCu, Al-Si-Cu, etc. can be used.

That is, as illustrated in Fig. 1(c), the Ni plating layer 22 and the Au plating layer 23 are not formed on the wide part 12a of the ground electrode pattern 12, which is covered with the insulating film 20, and the wide part 12a in an exposed state, which is formed of, for example, copper foil, opposes the magnetic sensor 21 across the insulating film 20. Thus, the Ni plating layer 22 does not exist directly below the magnetic sensor 21.

As illustrated in Figs. 1(a) and 1(c), the electrode pad 21a of the magnetic sensor 21 and an exposed part 12c of the ground electrode pattern 12 are conductively connected by wire bonding. At the exposed part 12c, since the Au plating layer 23 is formed on the copper foil surface on the Ni plating layer 22, the Au plating layer 23 can be formed with good adhesiveness, and high reliability is achieved. As illustrated in Fig. 1(a), the electrode pads 21b, 21c, and 21d of the magnetic sensor 21 are connected, by wire bonding, to the surfaces of the input electrode pattern 13 and the output electrode patterns 14 and 15.

As described above, in this embodiment, the insulating film 20 is interposed between the magnetic sensor 21 and the ground electrode pattern 12, and the Au plating layer 23 is formed only on the exposed part 12c of the ground electrode pattern 12, which is not covered with the insulating film 20, on the Ni plating layer 22. Then, the exposed part 12c at a distance and the magnetic sensor 21 are connected by wire bonding from the magnetic sensor 21 through the insulating film 20.

Thus, in this embodiment, the magnetizable Ni plating layer 22 is not disposed below the magnetic sensor 21, and the Ni plating layer 22 is disposed at a position a distance from the magnetic sensor 21 (position of the exposed part 12c). Therefore, as illustrated in Fig. 1(a), in also the configuration in which the magnetic sensor 21 is stacked on the ground electrode pattern 12 in plan view, the effect of magnetism from the Ni plating layer 22 on the magnetic sensor 21 can be prevented, and size reduction, as well as highly precise magnetic detection, is possible.

In the embodiment illustrated in Fig. 1, the magnetic sensor 21 is mounted on the ground electrode pattern 12 on the insulating film 20. Furthermore, the ground electrode pattern 12 includes the wide part 12a, and the magnetic sensor 21 is mounted within the wide part 12a in plan view, as illustrated in Fig. 1(a). In this way, the shielding effect of the ground electrode pattern 12 can be appropriately realized; and since the resistance of the ground electrode pattern 12 itself can be sufficiently reduced, electric field noise can be reduced even more effectively.

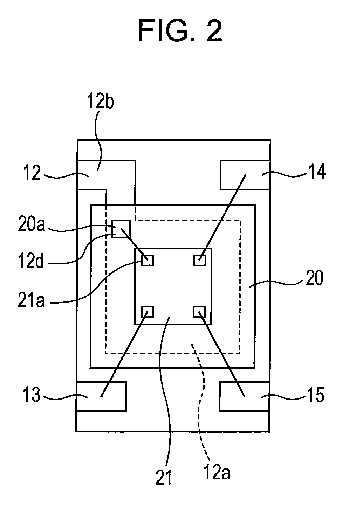

Fig. 2 is a plan view of a magnetic detection device according to a second embodiment. The embodiment illustrated in Fig. 2 has a configuration in which part of the magnetic detection device illustrated in Fig. 1 is modified. That is, in the embodiment illustrated in Fig. 2, an opening 20a reaching the ground electrode pattern 12 is formed in the insulating film 20, and the ground electrode pattern 12 exposed through the opening 20a constitutes the exposed part 12d, where the Au plating layer 23 is formed on the copper foil surface on the Ni plating layer 22. Then, the electrode pad 21a of the magnetic sensor 21 is connected to the exposed part 12d in the opening 20a by wire bonding.

In this embodiment also, the ground electrode pattern 12 is covered with the insulating film 20, except from the narrow part 12b and the exposed part 12d in the opening 20a, and the Ni plating layer 22 does not exist below the magnetic sensor 21. As illustrated in Fig. 2, the opening 20a is provided at a position a distance from the magnetic sensor 21 so that the magnetic effect of the Ni plating layer 22 disposed in the opening 20a to the magnetic sensor 21 can be sufficiently prevented, enabling highly precise magnetic detection.

As illustrated in Fig. 2, by forming the opening 20a in the insulating film 20, most of the ground electrode pattern 12 can be covered with the insulating film 20. That is, the area of the narrow part 12b of the ground electrode pattern 12, which is illustrated Fig. 2, can also be covered with the insulating film 20. In this way, the area of the ground electrode pattern 12 on which the Ni plating layer 22 is formed can be minimized. Moreover, the position of the opening 20a can be set freely. That is, with the configuration illustrated in Fig. 1(a) in which the opening 20a is not disposed, wire bonding must be provided on the patterned parts exposed to at outside the insulating film 20, but with the configuration in which the opening 20a is disposed, the formation position of the opening 20a can be set freely by taking into consideration the wire bonding positions of the input electrode pattern 13 and the output electrode patterns 14 and 15 so long as the ground electrode pattern 12 is provided therebelow; and thus, regardless of the leading of the electric patterns, wire bonding can be appropriately and stably performed. As illustrated in Fig. 2, by forming the wide part 12a with an area sufficiently larger than that of the magnetic sensor 21 on the ground electrode pattern 12 and mounting the magnetic sensor 21 thereon on the insulating film 20, the flexibility of the formation position of the opening 20a can be increased even more.

However, the opening 20a must be formed at a position that is 0.2 mm or more apart from the magnetic sensor 21. This is because when the opening 20a is too close to the magnetic sensor 21, the magnetic sensor 21 is affected by the magnetism from the Ni plating layer 22, more likely causing a reduction in the detection precision. The distance is set in a similar manner for the configuration in which the opening 20a is not formed in the insulating film 20, as illustrated in Fig. 1.

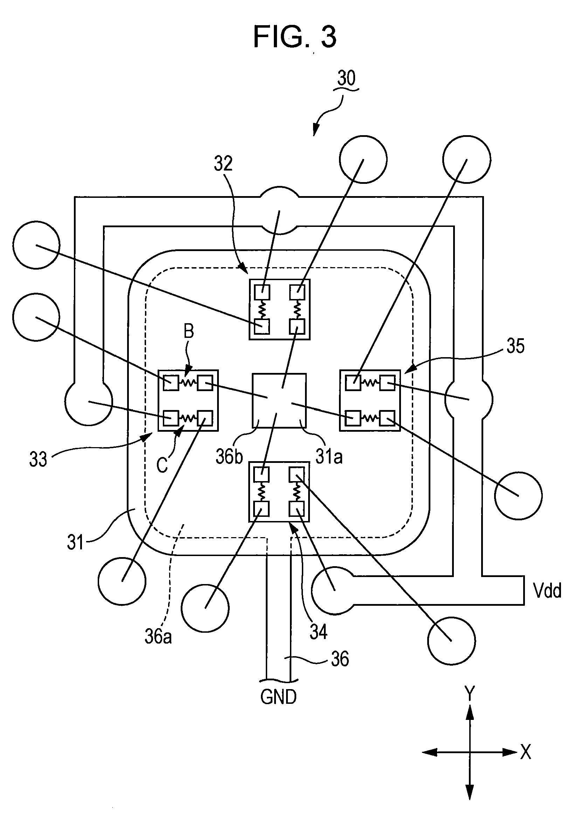

Next, Fig. 3 is a plan view of a magnetic detection device according to a third embodiment.

In the magnetic detection device 30 illustrated in Fig. 3, four magnetic sensors 32 to 35 are mounted on an insulating film 31. As illustrated in Fig. 3, one opening 31a is formed in substantially the center of the insulating film 31, and an exposed part 36b of a ground electrode pattern 36, where the Au plating layer 23 is formed on the copper foil surface on the Ni plating layer 22. In this configuration also, a wide part 36a, excluding the opening 31a, is formed of only copper foil, and the Ni plating layer 22 is not formed below the magnetic sensors 32 to 35. As illustrated in Fig. 3, the magnetic sensors 32 and 34 oppose each other at a predetermined distance across the opening 31a in the Y direction, and the magnetic sensors 33 and 35 oppose each other at a predetermined distance across the opening 31a in the X direction.

As illustrated in Fig. 3, two magnetic detection two elements B and C are embedded in each of the magnetic sensors 32 to 35. Then, four electrode pads are disposed on each of the surfaces of the magnetic sensors 32 to 35, and the electrode pads and the magnetic detection element are electrically connected. The magnetic sensor 32 and the magnetic sensor 34 constitute a bridge circuit, whereas the magnetic sensor 33 and the magnetic sensor 35 constitute a bridge circuit.

The magnetic detection device 30, which is illustrated in Fig. 3, is used as, for example, a pointing device and is capable of detecting movement of a magnet (not shown) in the X direction or the Y direction.

The wide part 36a is provided in the ground electrode pattern 36, which is illustrated in Fig. 3. The wide part 36a is formed with a size sufficient for encompassing the magnetic sensor 32 to 35 and the opening 31a in plan view. Then, as illustrated in Fig. 3, the magnetic sensors 32 to 35 are mounted on the wide part 36a on the insulating film 31. In Fig. 3, the magnetic sensors 32 to 35 surround the periphery of the opening 31a. Then, the exposed part 36b of the ground electrode pattern 36 formed in the opening 31a and the electrode pad, which is the ground electrode of the magnetic sensors 32 to 35, are connected by wire bonding. As illustrated in Fig. 3, the magnetic sensors 32 to 35, the input electrode pattern, and the output electrode patterns are connected by wire bonding.

In the embodiment illustrated in Fig. 3, unlike Figs. 1 and 2, a plurality of magnetic sensors 32 to 35 is provided. Then, one opening 31a is formed in the insulating film 31, and the magnetic sensors 32 to 35 are connected to the exposed part 36b of the ground electrode pattern 36 formed in the opening 31a by wire bonding. By providing the shared opening 31a in the insulating film 31 in this way, size reduction of the magnetic detection device can be promoted, compared with when openings are provided separately and wire-bonded or when wires are lead out for connection to the position of the ground electrode pattern 36 exposed outside the insulating film 31.

In particular, in the embodiment illustrated in Fig. 3, a plurality of magnetic sensors 32 to 35 surround the periphery of the opening 31a formed substantially at the center of the insulating film 31; the magnetic sensors 32 to 35 are electrically connected to the exposed part 36b of the ground electrode pattern 36 formed in the opening 31a by leading out wires inward to the insulating film 31 and electrically connected to the input electrode pattern and output electrode patterns disposed outside the insulating film 31 by leading out wires outward to the insulating film 31. In this way, interference between the wires connecting the magnetic sensors 32 to 35 and the ground electrode pattern 36 and the wires connecting the magnetic sensor 32 to 35, the input electrode pattern, and the output electrode patterns does not have to be considered, and wire bonding can be performed even more appropriately and stably.

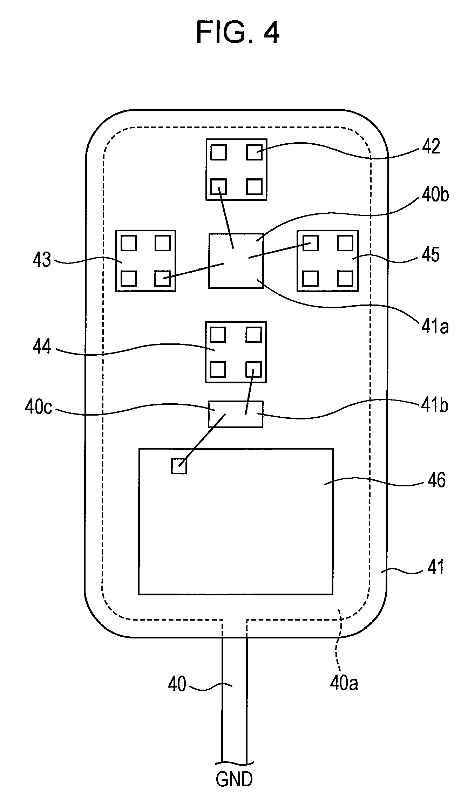

A fourth embodiment illustrated in Fig. 4 has a configuration in which part of Fig. 3 is modified. In Fig. 4, the input electrode pattern, the output electrode patterns, and the wires connecting these patterns by bonding are omitted from the drawing.

In the embodiment illustrated in Fig. 4, magnetic sensors 42 to 45 and an IC 46 are mounted on a wide part 40a of a ground electrode pattern 40 on an insulating film 41.

As illustrated in Fig. 4, for example, two openings 41a and 41b are formed in the insulating film 41, and in these openings 41a and 41b, exposed parts 40b and 40c of the ground electrode pattern 40, where a Au plating layer is formed on a copper foil surface constituting electrode patterns on a Ni plating layer, are formed. In this embodiment, also, the wide part 40a of the ground electrode pattern 40, excluding the positions of the openings 41a and 41b, is constituted of only copper foil, and the Ni plating layer and the Au plating layer are not formed.

In the embodiment in Fig. 4, the magnetic sensors 42, 43, and 45 are connected by wire bonding to the exposed part 40b of the ground electrode pattern 40 formed in the first opening 41a, and the magnetic sensor 44 and the IC 46 are connected by wire bonding to the exposed part 40c of the ground electrode pattern 40 formed in the second opening 41b.

In this way, by mounting the magnetic sensors 42 to 45 and the IC 46 on the shared ground electrode pattern 40 on the insulating film 41 and wire bonding the magnetic sensors 42 to 45 and the exposed part 40b of the ground electrode pattern 40 and the IC 46 and the exposed part 40c of the ground electrode pattern 40, the ground electrode pattern 40 does not have to be lead out separately to the magnetic sensors 42 to 45 and the IC 46. Furthermore, as illustrated in Fig. 4, the openings 41a and 41b can be formed in the insulating film 41, and wire bonding can be performed to the magnetic sensor 44 and the IC 46 at the shared opening 41b. In this way, by forming the ground electrode pattern 40 shared by the magnetic sensors 42 to 45 and the IC 46 and forming a shared opening in the insulating film 41 formed on the ground electrode pattern 40 for wire bonding of the magnetic sensors and the IC, wire bonding can be appropriately and stably performed, and size reduction of the magnetic detection device can be even more effectively promoted.

### Reference Signs List

10, 30 magnetism detection device
11 substrate
12, 36, 40 ground electrode pattern
12a, 36a, 40a wide part
12c, 12d, 36b, 40b, 40c exposed part
13 input electrode pattern
14, 15 output electrode pattern
20, 31, 41 insulating film
20a, 31a, 41a, 41b opening
21, 32 to 35, 42 to 45 magnetic sensor
22 Ni plating layer
23 Au plating layer (connecting surface layer)

## Claims

1. A magnetic detection device comprising:
a magnetic sensor,
wherein the magnetic sensor is mounted on an electrode pattern formed on a substrate on an insulating film, and the insulating film is formed with a size spreading out around the magnetic sensor,
wherein the electrode pattern is provided with an exposed part where a connecting surface layer is formed on the electrode pattern surface on a Ni plating layer and not covered with the insulating layer, and
the magnetic sensor is connected by wire bonding to the exposed part at a distance from the magnetic sensor through the insulating film.

2. The magnetic detection device according to Claim 1, wherein an opening reaching the electrode pattern is formed in the insulating film at a position a distance from the magnetic sensor, and the magnetic sensor is connected by wire bonding to the exposed part formed in the opening.

3. The magnetic detection device according to Claim 1 or 2, wherein
the magnetic sensor is mounted on a ground electrode pattern on the insulating film, an input electrode pattern and an output electrode pattern are disposed at positions a distance from the insulating film, and a connecting surface layer is formed on the pattern surfaces of the input electrode pattern and the output electrode pattern on a Ni plating layer, and
the magnetic sensor is connected by wire bonding to each of the exposed part of the ground electrode pattern, the input electrode pattern, and the output electrode pattern.

4. The magnetic detection device according to Claim 3, wherein the ground electrode pattern includes a narrow part and a wide part, and the magnetic sensor is mounted within the wide part in plan view.

5. The magnetic detection device according to Claim 3 or 4, wherein a plurality of magnetic sensors is mounted on the ground electrode pattern on the insulating film, a shared opening reaching the ground electrode pattern is formed in the insulating film at a position a distance from the magnetic sensors, and the magnetic sensors are connected by wire bonding to the exposed part formed in the shared opening.

6. The magnetic detection device according to Claim 5, wherein the magnetic sensors surround the shared opening and are connected by wire bonding to the exposed part formed in the shared opening, and wires are lead out from electrode pads of the magnetic sensors to outside the insulating film and connected to the input electrode pattern and the output electrode pattern.

7. The magnetic detection device according to one of Claims 3 to 6, wherein
the magnetic sensor and an IC are mounted on the same ground electrode pattern on the insulating film, and
the IC, together with the magnetic sensor, is connected by wire bonding to the exposed part of the ground electrode pattern.

## Amended claims

### Amended claims under Art. 19.1 PCT

**1.** (Amended) A magnetic detection device comprising:
a magnetic sensor,
wherein the magnetic sensor is mounted on an electrode pattern formed on a substrate on an insulating film, and the insulating film is formed with a size spreading out around the magnetic sensor,
wherein the electrode pattern is provided with an exposed part where a connecting surface layer is formed on the electrode pattern surface on a Ni plating layer and not covered with the insulating layer,
the magnetic sensor is connected by wire bonding to the exposed part at a distance from the magnetic sensor through the insulating film,
the magnetic sensor is mounted on a ground electrode pattern on the insulating film, an input electrode pattern and an output electrode pattern are disposed at positions a distance from the insulating film, and a connecting surface layer is formed on the pattern surfaces of the input electrode pattern and the output electrode pattern on a Ni plating layer, and
the magnetic sensor is connected by wire bonding to each of the exposed part of the ground electrode pattern, the input electrode pattern, and the output electrode pattern.

**2.** The magnetic detection device according to Claim 1, wherein an opening reaching the electrode pattern is formed in the insulating film at a position a distance from the magnetic sensor, and the magnetic sensor is connected by wire bonding to the exposed part formed in the opening.

**3.** (Amended) The magnetic detection device according to Claim 1 or 2, wherein the ground electrode pattern includes a narrow part and a wide part, and the magnetic sensor is mounted within the wide part in plan view.

**4.** (Amended) The magnetic detection device according to Claim 1 or 3, wherein a plurality of magnetic sensors is mounted on the ground electrode pattern on the insulating film, a shared opening reaching the ground electrode pattern is formed in the insulating film at a position a distance from the magnetic sensors, and the magnetic sensors are connected by wire bonding to the exposed part formed in the shared opening.

**5.** (Amended) The magnetic detection device according to Claim 4, wherein the magnetic sensors surround the shared opening and are connected by wire bonding to the exposed part formed in the shared opening, and wires are lead out from electrode pads of the magnetic sensors to outside the insulating film and connected to the input electrode pattern and the output electrode pattern.

**6.** (Amended) The magnetic detection device according to one of Claims 1 to 5, wherein
the magnetic sensor and an IC are mounted on the same ground electrode pattern on the insulating film, and
the IC, together with the magnetic sensor, is connected by wire bonding to the exposed part of the ground electrode pattern.

**7.** (Amended) A magnetic detection device comprising:
a magnetic sensor,
wherein the magnetic sensor is mounted on an electrode pattern formed on a substrate on an insulating film, and the insulating film is formed with a size spreading out around the magnetic sensor,
wherein the electrode pattern is provided with an area opposing the magnetic sensor in the height direction and covered with the insulating film and an exposed part electrically connected to the area and having a connecting surface layer formed in the exposed part on the electrode pattern surface on a Ni plating layer and not covered with the insulating layer, and
the magnetic sensor is connected by wire bonding to the exposed part at a distance from the magnetic sensor through the insulating film.
